## Europäisches Patentamt
## European Patent Office
## Office européen des brevets

(11) Numéro de publication: **0 262 016**
**A1**

## DEMANDE DE BREVET EUROPEEN

(21) Numéro de dépôt: **87401955.7**

(22) Date de dépôt: **01.09.87**

(51) Int. Cl.⁴: **G 01 R 33/032**

(30) Priorité: **05.09.86 FR 8612507**

(43) Date de publication de la demande:
**30.03.88 Bulletin 88/13**

(84) Etats contractants désignés: **DE GB IT**

(71) Demandeur: **THOMSON-CSF**
**173, Boulevard Haussmann**
**F-75379 Paris Cédex 08 (FR)**

(72) Inventeur: **Meunier, Paul-Louis**
**THOMSON-CSF SCPI 19, avenue de Messine**
**F-75008 Paris (FR)**

**Doriath, Gérard**
**THOMSON-CSF SCPI 19, avenue de Messine**
**F-75008 Paris (FR)**

**Razeghi, Manijeh**
**THOMSON-CSF SCPI 19, avenue de Messine**
**F-75008 Paris (FR)**

(74) Mandataire: **Lepercque, Jean et al**
**THOMSON-CSF SCPI 19, avenue de Messine**
**F-75008 Paris (FR)**

(54) **Tête de mesure de champ magnétique intégrée et son procédé de réalisation.**

(57) L'invention concerne une tête de mesure de champ magnétique comprenant, intégrés sur un même substrat (1) : une source lumineuse (E1) ; un guide de lumière (G1) insensible au champ magnétique ; une couche de matériau magnétique (F1), permettant lorsqu'elle est plongée dans un champ magnétique à mesurer, de faire tourner le plan de polarisation de la lumière venant de la source ; et des moyens de mesure de rotation du plan de polarisation de la lumière.

L'invention est applicable aux magnétomètres.

FIG_1

**Description**

TETE DE MESURE DE CHAMP MAGNETIQUE INTEGREE ET SON PROCEDE DE REALISATION

L'invention concerne une tête de mesure de champ magnétique, utilisant l'effet du champ magnétique sur la polarisation de la lumière et dans laquelle la source lumineuse, l'élément sensible au champ magnétique, le détecteur, tout élément de transmission optique entre ces éléments ainsi que l'électronique de traitement du signal détecté sont réalisés monolithiquement sur un même substrat. Cette tête de mesure est applicable à la mesure de champ magnétique où à la mesure de vecteur gradient de champ magnétique, selon les modes de réalisation.

L'invention concerne également un procédé de réalisation permettant de réaliser une telle tête.

On connait des têtes de mesure pour appareil de mesure de champ magnétique mettant à profit l'influence d'un champ magnétique sur la polarisation de la lumière pour mesurer ce champ magnétique.

C'est ainsi que le brevet français no 76 18600 déposé 18 juin 1976 et publié sous le no 2 355 299 le 13 janvier 1978 décrit un appareil qui comprend :

- une source lumineuse émettant un faisceau lumineux polarisé linéairement ;

- une couche mince plane d'un matériau magnétique plongée dans le champ magnétique à mesurer et permettant de propager le faisceau lumineux de façon guidée ;

- un détecteur recevant le faisceau lumineux après sa traversée de la couche mince de matériau magnétique et mesurant l'intensité lumineuse du faisceau.

Le faisceau lumineux est propagé dans la couche mince selon un mode unique, TM par exemple. En raison de l'effet Faraday, sous l'effet du champ magnétique, le mode de propagation se convertit en mode TE avec un pourcentage plus ou moins grand selon la valeur du champ magnétique. On obtient une rotation du plan de polarisation de la lumière que le détecteur peut mesurer.

Selon un autre mode de réalisation connu et décrit dans le brevet français no 79 30721 déposé le 14 décembre 1979 et publié sous le no 2 471 608 le 19 juin 1981, l'élément de propagation du faisceau lumineux placé dans le champ magnétique à mesurer est une couche épaisse en matériau magnétique permettant une transmission lumineuse multimode. Comme précédemment, en raison de l'effet Faraday, le faisceau lumineux subit une rotation de son plan de polarisation en présence d'un champ magnétique. La rotation de cette polarisation se fait à l'aide de polariseurs croisés.

Un tel dispositif a été appliqué à la réalisation d'un dispositif de mesure de gradient de champ magnétique dans la demande de brevet français no 83 11073 déposée le 4 juillet 1983. Dans ce dispositif, on prévoit de placer deux cellules de mesure de champ magnétique sur un seul faisceau lumineux. De cette façon, on est à même de mesurer un gradient de champ magnétique selon une direction qui est déterminée par la direction du faisceau lumineux. Ce brevet décrit, par ailleurs, un système permettant d'effectuer des mesures de l'effet Faraday par une méthode de zéro à l'aide d'enroulements auxiliaires émettant un champ magnétique annulant le champ à mesurer.

Cependant, les dispositifs connus ne sont pas réalisés de façon monolithique et leur conception ne permet pas une telle réalisation. De ce fait, ils se présentent sous la forme d'une association de composants hybrides ; ce qui pose deux problèmes essentiels :

- les performances des composants sont difficilement reproductibles ;

- l'implantation des composants les uns par rapport aux autres demande beaucoup de précautions.

La tête de mesure de champ magnétique selon l'invention et son procédé de réalisation permettent de palier ces inconvénients.

C'est pourquoi l'invention a pour objet une tête de mesure de champ magnétique intégrée comprenant :

- une source lumineuse émettant un premier faisceau de lumière polarisée linéairement ;

- une première couche plane de matériau magnétique placée sur le trajet dudit faisceau de lumière et plongée dans un champ magnétique à mesurer qui a pour effet de faire tourner le plan de polarisation de la lumière ;

- des premiers moyens de mesure de rotation du plan de polarisation de la lumière placés sur le trajet dudit faisceau après traversée de la couche de matériau magnétique ;

caractérisé en ce que la source lumineuse et la couche de matériau magnétique sont intégrées sur un même substrat et possèdent chacune un paramètre de maille égal, multiple ou sous-multiple de celui du substrat (1), la source lumineuse étant couplée à la couche de matériau magnétique par un premier guide de lumière intégré sur ledit substrat et insensible au champ magnétique.

L'invention a également pour objet un procédé de réalisation d'une telle tête de mesure, caractérisé en ce qu'il comporte les différentes phases successives suivantes :

- a) une première phase d'usinage dans un substrat d'un premier guide de lumière possédant une première et une deuxième extrémité ;

- b) une deuxième phase de masquage dudit guide de lumière ainsi réalisé ;

- c) une troisième phase de croissance d'une première couche d'un matériau ferrimagnétique disposée à la deuxième extrémité dudit guide de lumière ;

- d) une quatrième phase de croissance sur le substrat dans une zone accolée à la première extrémité du guide de lumière, d'une diode émissive dont le matériau possède un paramètre de maille sensiblement égal, multiple ou sous-multiple de celui du substrat ;

- e) une cinquième phase de croissance sur le substrat dans une zone accolée à la première couche de matériau ferrimagnétique, d'une diode réceptrice dont le matériau possède un paramètre de maille sensiblement égal, multiple ou sous multiple de celui du substrat ;

- f) une sixième phase de réalisation de circuits de traitement.

Les différents objets et caractéristiques de l'invention apparaîtront plus clairement dans la description qui va suivre faite en se reportant aux figures annexées qui représentent :

- la figure 1, premier mode de réalisation d'une tête de mesure applicable à la mesure du champ magnétique selon l'invention ;

- la figure 2, un exemple d'un second mode de réalisation d'une tête de mesure selon l'invention applicable à la mesure de gradient de champ magnétique, selon l'invention ;

-la figure 3, une variante du second mode de réalisation d'une tête de mesure pour la mesure de gradient de champ magnétique, selon l'invention.

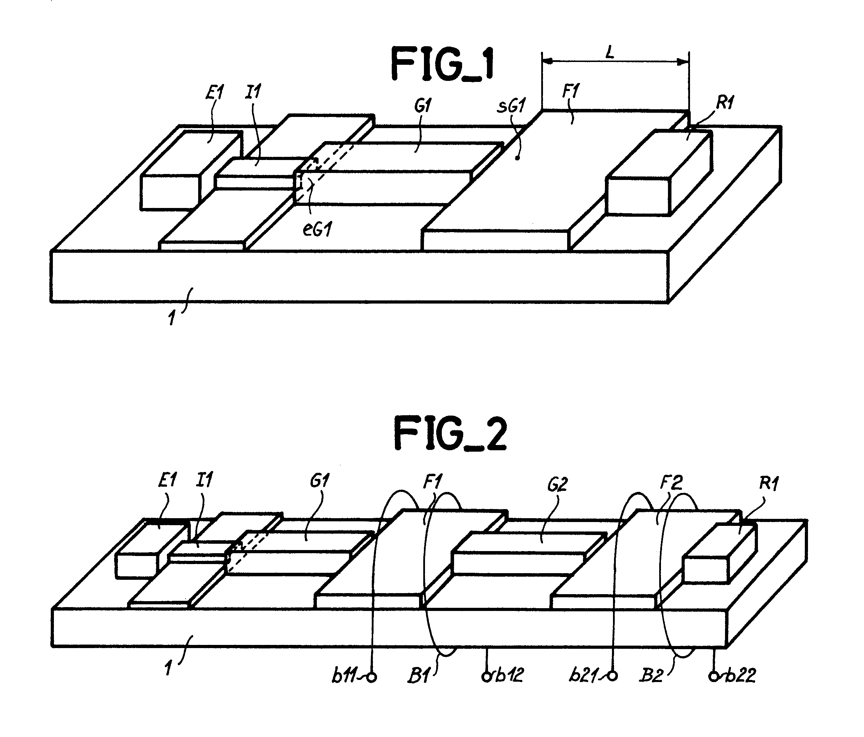

En se reportant à la figure 1, on va tout d'abord décrire un exemple de réalisation d'une tête de mesure intégrée applicable à la mesure de champ magnétique selon l'invention.

La croissance par épitaxie en phase vapeur d'organométallique à pression réduite ou LP-MOCVD (Low Pressure-Metalorganic chemical Vapor Deposition en terminologie anglo-saxonne), de composés semiconducteurs sur GGG ou YIG permet de faire coexister source laser et guide de lumière fonctionnant à des longueurs d'ondes comprises entre 1,1 um et 4,7 um, sur un même substrat, donc de réaliser une intégration totale pour tout système nécessitant ces deux éléments.

L'invention concerne une réalisation monolithique d'un détecteur de champ magnétique. Source, guide lumière, élément sensible au champ magnétique, détecteur et électronique de traitement du signal de sortie, sont réalisés sur le même support. De plus, la combinaison peut inclure un isolateur (monomode ou multimode) entre source et guide tel que cela va être décrit, ouvre des perspectives de pureté du signal d'émission importantes.

L'epitaxie de matériaux III-V sur GGG permet d'élaborer une diode à la longueur d'onde voulue sur un substrat comportant un guide de lumière en YIG par exemple. La partie sensible, couche mince massive de YIG optimisée au niveau de sa composition chimique (substitution envisagée Bi par exemple) ou même un guide de YIG dopé de façon adaptée, est solidaire du guide de lumière. De même la diode réceptrice et son guide associé à partir de laquelle on traite le signal reçu, peuvent avoir l'électronique de traitement sur le substrat.

Sur la figure 1, on trouve donc sur un substrat 1 en matériau isolant dont les caractéristiques sont insensibles au champ magnétique, tel qu'un Grenat de Gadolinium et Gallium GGG, une source de lumière polarisée E1 telle qu'une diode laser. Cette diode laser est en matériau semiconducteur présentant un paramètre de maille égal, multiple ou sous-multiple du paramètre de maille du matériau constituant le substrat. Ainsi cette diode se prête bien à une implantation par un procédé de croissance par MOCVD.

Le substrat est par exemple un grenat de Gadolinium et gallium, dont le paramètre de maille est de 12,383 Angströms et la diode laser peut être constituée par des éléments des classes III et V ou (II-VI) de la classification périodique des éléments. Par ailleurs, dans les classes III-V, on choisira des éléments permettant d'obtenir des émissions lasers de longueur onde d'environ 1,3 microns à 1,5 microns. C'est ainsi que, de préférence, on choisira par exemple une composition de In Ga Al Sb dont le paramètre de maille est 6,19 Angströms.

Cette diode laser émet un faisceau de lumière polarisée vers un guide de lumière G1. Ce guide de lumière G1 est réalisé en un matériau analogue à celui du substrat 1 de telle façon que ses caractéristiques physiques soient insensibles au champ magnétique.

Selon une réalisation préférée de l'invention, ce guide de lumière est usiné dans le substrat (1) lui-même et en fait partie intégrante.

Le guide de lumière est réalisé selon la direction du faisceau lumineux émis par la source E1 de façon à le guider. Il reçoit le faisceau lumineux par une première extrémité eG1 et le retransmet à une deuxième extrémité sG1.

Une couche mince d'un matériau magnétique F1 est disposée sur le substrat de façon à recevoir le faisceau lumineux transmis par le guide G1 à la deuxième extrémité sG1.

Cette couche est en matériau ferrimagnétique dont le paramètre de maille est égal, multiple ou sous-multiple de celui du substrat de façon à pouvoir être réalisé par une croissance épitaxiale qui permet d'obtenir une couche mince, d'épaisseur régulière et de qualité parfaite. Pour que la transmission dans cette couche soit monomode son épaisseur sera de l'ordre de quelques micromètres.

Enfin, selon la direction du faisceau lumineux transmis par la source E1, du côté opposé à l'extrémité sG1 par rapport à la couche mince F1, est disposé un détecteur de lumière R1 tel qu'une diode de détection. Ce détecteur est réalisé en matériau semiconducteur dont le paramètre de maille est égal, multiple ou sous-multiple de celui du substrat de façon à ce qu'il puisse être réalisé, comme les éléments précédents, par croissance épitaxiale.

Par ailleurs, pour éviter les réflexions parasites pouvant venir perturber le fonctionnement de la source lumineuses E1, l'invention prévoit entre la source lumineuse E1 et le guide de lumière G1 un élément de transmission non récipropque I1.

Un tel élément de transmission non réciproque ou isolateur a été décrit dans la demande de brevet français nᵒ 84 18928 déposée le 11 décembre 1984. Il sera réalisé, par exemple en matériau ferrimagnétique tel qu'un grenat d'yttrium et de fer (YIG) dont le paramètre de maille s'adapte bien à celui du substrat 1 ce qui permet également sa réalisation par croissance épitaxiale. Pour que cet élément de transmission soit monomode, ses dimensions seront de l'ordre de quelques micromètres pour la largeur ainsi que pour la hauteur et cela selon la nature et notamment l'indice de réfraction des

matériaux encadrant le guide. Sa longueur b sera par exemple de quelques millimètres.

Le faisceau lumineux émis par la source E1 subit, lors de la traversée de la couche ferrimagnétique F1 une rotation de son plan de polarisation en raison de l'Effet Faraday dû au champ magnétique régnant.

La tête de mesure ainsi décrite permet ainsi de détecter un champ magnétique existant à l'endroit où se trouve la couche mince ferrimagnétique F1. La mesure s'effectue sur la longueur L de parcours. Le guide de lumière G1 étant insensible au champ magnétique, le faisceau lumineux n'est pas influencé dans le guide G1 par le champ magnétique.

De plus, le guide de lumière G1 permet de déporter la couche mince ferrimagnétique F1 par rapport à la source lumineuse E1 pour éviter que l'alimentation en courant de la source E1 provoque un champ magnétique qui risque d'influencer la couche mince F1. La distance source E1 - couche F1 pourra être de l'ordre de 10 cm par exemple pour assurer une bonne insensibilité de la couche F1 par rapport à toute radiation magnétique de la source E1.

Bien que cela ne soit pas représenté sur la figure 1, les circuits de traitement des signaux issus du détecteur de lumière R1 peuvent être implantés sur le substrat 1.

De même, n'ont pas été représentés sur la figure 1, les dispositifs (bobinages) d'induction de champs magnétiques prévus dans les documents précédemment cités et permettant d'effectuer des mesures plus précises de la rotation du plan de polarisation de la lumière. Ces dispositifs seront disposés, comme cela est décrit dans les documents cités, à proximité de la couche mince de matériau ferrimagnétique F1 dans laquelle s'effectue la rotation du plan de polarisation de la lumière à mesurer.

En se reportant à la figure 2, on va maintenant décrire un mode de réalisation de la tête de mesure selon l'invention applicable à la mesure de gradient de champ magnétique.

On retrouve dans la tête de mesure de la figure 2 les éléments de la figure 1 portant les mêmes références. Il s'agit de la source lumineuse E1, l'élément de transmission non réciproque I1, le guide de lumière G1, la couche de matériau ferrimagnétique F1 et le détecteur R1.

Entre la couche de matériau magnétique F1 et le détecteur R1 se trouve un guide de lumière G2 et une deuxième couche mince le matériau magnétique F2 tous deux placés sur le trajet du faisceau lumineux émis par la source E1.

Le guide de lumière G2 est en matériau dont les caractéristiques sont insensibles à l'influence du champ magnétique. Il est de conception analogue à celle du guide de lumière G1. Par exemple, il est en un même matériau que le substrat 1 et selon un mode de réalisation préféré de l'invention, il est usiné dans le substrat 1.

La couche de matériau magnétique F2 est identique à la couche de matériau magnétique F1, aux imperfections de réalisation près. Par exemple, son épaisseur sera de quelques micromètres et elle sera réalisé en matériau ferrimagnétique, tel qu'un grenat d'yttrium et de fer, épitaxié sur le substrat 1.

Chaque couche mince ferrimagnétique F1 et F2 est placée à l'intérieur d'un dispositif d'induction de champ magnétique tel que des bobinages B1 et B2. Ces bobinages sont alimentés en courant par des bornes d'entrée b11, b12, b21, b22. Ils permettent de compenser le champ magnétique ambiant régnant à l'emplacement de chacune des couches minces F1 et F2. La compensation est obtenue lorsque le détecteur R1 détecte une même intensité lumineuse que celle détectée en l'absence de champ magnétique. La différence des courants fournis aux deux bobinages B1 et B2 permet d'indiquer la valeur du vecteur de gradient le champ magnétique à l'emplacement de la tête de mesure selon une direction définie par la direction du faisceau lumineux fourni par la source E1.

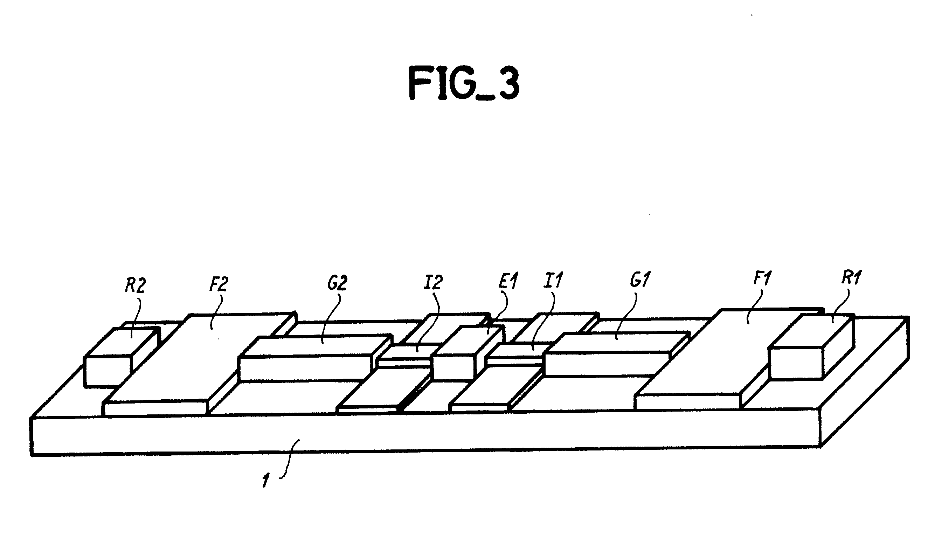

La figure 3, représente une variante du mode de réalisation de la tête représenté sur la figure 2.

Les éléments de la figure 3 remplissant la même fonction que ceux de la figure 2 portent les mêmes références que sur la figure 2.

A la différence de la tête de la figure 2, celle de la figure 3 possède ses guides de lumière G1 et G2 et ses couches minces ferrimagnétiques F1 et F2 disposés de part et d'autre de la source lumineuse E1 sur le faisceau lumineux émis par la diode laser E1.

De ce fait, entre le guide de lumière G2 et la source E1 est prévu un élément de transmission non réciproque I2. De plus, un détecteur R2 est associé à la couche ferrimagnétique F2 pour détecter le faisceau provenant de la source E1 et ayant traversé la couche ferrimagnétique F2.

Les faisceaux lumineux émis par la source E1 sont colinéaires. Chacun d'eux est transmis à une couche mince ferrimagnétique F1, F2 et selon la valeur du champ magnétique régnant à l'emplacement de chaque couche F1, F2, le faisceau lumineux subit une rotation de son plan de polarisation. Chaque récepteur R1, R2 détecte l'intensité du faisceau lumineux reçu et en déduit la rotation du plan de polarisation du faisceau. Des circuits de traitement non représentés qui peuvent également être implantés sur le substrat déterminent la différence des résultats fournis par les détecteurs pour obtenir la valeur du vecteur gradient de champ magnétique selon la direction des faisceaux lumineux à l'emplacement de la tête de mesure.

Des dispositif d'induction de champ magnétique similaires à ceux de la tête de la figure 2 peuvent être également prévus. Dans ce cas, la tête de mesure de la figure 3 fonctionnera de la même façon que celle de la figure 2. En effet, les dispositifs d'induction émettront chacun un champ magnétique qui compensera dans chaque couche mince F1, F2, le champ magnétique à mesurer. Chaque détecteur R1, R2 permettra de s'assurer que la compensation des champs magnétiques est réalisée convenablement. Des circuits non représentés permettront de déduire, des champs de compensation fournis, la valeur du vecteur gradient de champ magnétique à mesurer.

On va maintenant décrire un procédé permettant de réaliser les têtes décrites précédemment. Tout d'abord on va décrire un procédé de réalisation de la tête de la figure 1.

Au cours d'une première phase du procédé de réalisation, on procède à l'usinage dans un substrat 1 en matériau non magnétique, tel qu'un grenat de Gadolinium et gallium (GGG), du guide de lumière G1. La longueur de ce guide est par exemple d'environ 10 cm. Sa hauteur et sa largeur sont respectivement de l'ordre de 3 micromètres et quelques milliers d'angströms, mais pour ne pas être limitatif on peut envisager des dimensions 3 micromètres sur 3 micromètres.

Au cours d'une deuxième phase, on masque le guide ainsi réalisé.

Au cours d'une troisième phase, on procède à la croissance d'une couche d'un matériau ferrimagnétique tel qu'un grenat d'yttrium et de fer (YIG) dont l'épaisseur sera de l'ordre de quelques micromètres pour une transmission lumineuse monomode dans la couche ainsi réalisée ou de quelques dizaines de micromètres pour une transmission multimode.

Cette croissance de matériau se fait par un procédé d'épitaxie et de préférence par le procédé d'épitaxie en phase vapeur d'organométalliques (MOCVD = Metalorganic Chemical Vapor Deposition).

La couche de matériau ferrimagnétique est ensuite usinée de façon à déterminer les limites de propagation de la lumière dans la couche. Les dimensions seront de l'ordre de quelques mm pour la longueur selon la direction de propagation du faisceau lumineux et de 1/10 mm pour la largeur.

Au cours d'une quatrième phase on procède à la croissance d'une diode laser, dans une zone voisinant avec une extrémité du guide de lumière, à une distance inférieure à un micromètre de cette extrémité, de telle façon que la diode laser émette selon la direction du guide G1.

Le matériau épitaxié comprend des éléments des groupes III-V, tels que l'indium et l'Arsenic ou Indium, Gallium, Aluminium et Antimoine, dont la paramètre de maille est dans un rapport moitié du paramètre de maille du grenat de gadolinium et gallium.

Dans le cas, par exemple, d'une réalisation par épitaxie en phase vapeur d'organométalliques, l'épitaxie se fait entre 450 et 700 degrés Celsius sous une pression comprise entre 50 millibars et 500 millibars. La vitesse de dépôt, pour que l'adaptation entre le matériau épitaxié et le grenat de gadolinium et gallium se fasse correctement, est choisie de préférence entre 20 Angströms et 300 Angströms par minute.

La croissance de diodes lasers peut également se faire par épitaxie à jet moléculaire ou MBE (Molecular Beam Epitaxy) en terminologie anglo-saxonne).

Au cours d'une cinquième phase on réalise également, par croissance sur le substrat, une diode réceptrice (R1), selon un procédé analoque à celui de la quatrième phase.

La quatrième phase et la cinquième phase peuvent être confondues.

Au cours d'une sixième phase on réalise sur le substrat des circuits de traitement permettant de traiter les résultats de détection de la diode réceptrice (R1).

Pour réaliser une tête de mesure telle que celle de la figure 1, il convient de prévoir, à la fin ou à l'issue de la troisième phase, une phase de croissance par épitaxie en phase liquide d'une couche d'un matériau ferrimagnétique telle qu'une couche d'yttrium-fer (YIG). Cette épitaxie est réalisée à une température d'environ 980 degrés Celsius.

L'épaisseur de la couche réalisée dépend du domaine d'application de l'invention. Par exemple, pour des guides monomodes, la couche de YIG réalisée doit être mince, quelques microns par exemple, pour assurer la monomodicité des guides de transmission qui sont réalisés dans cette couche. Une épitaxie comportant plusieurs couches peut aussi être envisagée.

Pour des isolateurs en volume, l'épaisseur de la couche sera supérieure à vingt fois la longueur d'onde émise par la source.

La croissance de la couche ferrimagnétique peut également se faire par pulvérisation cathodique désignée aussi par "sputtering" en terminologie anglo-saxonne suivie d'un recuit.

Ensuite, des éléments de transmission non réciproques sont usinés dans la couche de YIG. Cet usinage se fait, par exemple, par usinage chimique à l'aide d'un acide orthophosphorique concentré, à température comprise entre 180 et 220° Celsius, ou par usinage ionique. Les guides réalisés ont une forme telle que représentée en figure 1.

Sur la figure 1, l'élément de transmission non réciproque est constitué par un profilé mésa comme représenté. Il peut être également obtenu par réalisation d'un canal dans la couche de matériau ferrimagnétique et constitution d'un guide sous le canal tel que cela est décrit dans le demande de brevet français no 84 18928 déjà citée.

L'invention concerne également un procédé de réalisation d'une tête de mesure applicable à la mesure de vecteur de gradient de champ magnétique. Ce procédé reprend le procédé décrit précédemment. Il prévoit qu'au cours de la première phase, deux guides G1 et G2 colinéaires sont réalisés en laissant un espace libre entre les deux.

Pour réaliser la tête de mesure de la figure 2, au cours de la troisième phase, deux couches F1 et F2 de matériau ferrimagnétique sont réalisées.

L'une des couches (F1) est réalisée entre les deux guides, l'autre couche (F2) est réalisée à l'extrémité opposée du guide G2 par rapport au guide G1.

Ensuite, l'élément de transmission non réciproque I1, la diode laser E1 et la diode réceptrice sont réalisés comme cela est décrit précédemment.

Pour réaliser la tête de mesure de la figure 3, au cours de la troisième phase, les deux couches F1 et F2 sont réalisées aux extrémités des guides G1 et G2 opposées à l'espace libre entre ces guides.

Ensuite, deux éléments de transmission non réciproques I1 et I2 sont réalisées aux extrémités des guides G1 et G2 dans l'espace laissé entre les guides.

Au cours de la quatrième phase, la diode laser E1 est réalisée entre les deux éléments de transmission non réciproques.

Enfin deux diodes réceptrices R1 et R2, au lieu d'une seule comme précédemment, sont réalisées chacune associée à une couche de matériau ferrimagnétique F1, F2. Puis des circuits de traitements exploitant les résultats de détection des diodes réceptices R1 et R2 sont réalisés sur le substrat.

Il est bien évident que les valeurs numériques fournies dans le description qui précède ont été données à titre d'exemple et que d'autres valeurs pourraient permettre d'obtenir le même résultat. De même, les types de matériaux n'ont été indiqués qu'à titre d'exemple. Ainsi, on a considéré un matériau semiconducteur constitué d'éléments des groupes III-V mais on peut également envisager des éléments des groupes II-VI.

## Revendications

1. Tête de mesure de champ magnétique intégrée comprenant :

- une source lumineuse (E1) émettant un premier faisceau de lumière polarisée linéairement ;

- une première couche plane de matériau magnétique (F1) placée sur le trajet dudit faisceau de lumière, quiµ lorsqu'elle est plongée dans un champ magnétique à mesurer, a pour effet de faire tourner la plan de polarisation de la lumière ;

- des premiers moyens de mesure (R1) de rotation du plan de polarisation de la lumière placés sur le trajet dudit faisceau après traversée de la couche de matériau magnétique (F1); caractérisé en ce que la source lumineuse (E1) et la couche de matériau magnétique (F1) sont intégrés sur un même substrat (1) et possèdent un paramètre de maille égal, multiple ou sous-multiple de celui du substrat, la source lumineuse (E1) étant couplée à la couche de matériau magnétique (F1) par un premier guide de lumière (G1) intégré sur ledit substrat et insensible au champ magnétique.

2. Tête de mesure selon la revendication 1, caractérisée en ce qu'elle comporte également un premier élément de transmission non réciproque (I1) couplant la source lumineuse (E1) au guide de lumière (G1).

3. Tête de mesure selon l'une quelconque des revendications précédentes, applicable à la mesure de vecteur de gradient de champ magnétique, caractérisée en ce qu'elle comporte en outre une deuxième couche mince de matériau magnétique (F2) placée entre la première couche de matériau magnétique (F1) et les premiers moyens de mesure (R1).

4. Tête de mesure selon la revendication 3, caractérisée en ce quelle comporte un deuxième guide de lumière (G2) couplant la première couche de matériau magnétique (F1) à la deuxième couche de matériau magnétique (F2) et permettant de transmettre le faisceau de lumière émis par la source lumineuse (E1).

5. Tête de mesure selon l'une des revendications 1 et 2 applicable à la mesure de vecteur de gradient de champ magnétique, caractérisée en ce que la source lumineuse (E) émet un deuxième faisceau lumineux colinéaire avec le premier mais de sens opposé, et qu'elle comporte des deuxièmes moyens de mesure (R2) placés sur le trajet de ce deuxième faisceau lumineux, et une deuxième couche de matériau magnétique (F2) placée sur le trajet de ce deuxième faisceau entre la source lumineuse (E) et les deuxièmes moyens de mesure.

6. Tête de mesure selon la revendication 5, caractérisée en ce qu'elle comporte un deuxième guide de lumière (G2) intégré sur le substrat et couplant la source lumineuse (E) à la deuxième couche de matériau magnétique (F2).

7. Tête de mesure selon la revendication 6, caractérisée en ce qu'elle comporte un deuxième élément de transmission non réciproque (I2) intégré sur le substrat (1) et couplant la source lumineuse (E) au deuxième guide de lumière (G2).

8. Tête de mesure selon l'une des revendications précédentes, caractérisée en ce que la ou les couches minces de matériau magnétique (F1, F2) sont intégrées sur le substrat (1).

9. Tête de mesure selon l'une des revendications 1, 3 et 5, caractérisée en ce que la ou les couches de matériau magnétique (F1, F2) sont en matériau ferrimagnétique.

10. Tête de mesure selon l'une des revendications 2 et 7, caractérisée en ce que le ou les éléments non réciproque (I1, I2) sont des guides de transmission en matériau ferrimagnétique.

11. Tête de mesure selon l'une des revendications 9 et 10, caractérisée en ce que le matériau ferrimagnétique est un grenat d'yttrium et de fer.

12. Tête de mesure selon l'une des revendications 1, 4 et 6, caractérisée en ce que le ou les guides (G1, G2) sont en même matériau que le substrat.

13. Tête de mesure selon la revendication 12, caractérisée en ce que le substrat (1) et le ou les guides (G1, G2) sont en grenat de Gadolinium et gallium.

14. Procédé de réalisation d'une tête de mesure de champ magnétique, selon des revendications 1 et 2, caractérisé en ce qu'il comporte les différentes phases successives suivantes :

- a) une première phase d'usinage dans un substrat (1) d'un premier guide de lumière (G1) possèdant une première et une deuxième extrémités ;

- b) une deuxième phase de masquage dudit guide de lumière (G1) ainsi réalisé ;

- c) une troisième phase de croissance d'une première couche d'un matériau ferrimagnétique disposée à la deuxième extrémité dudit guide de lumière (G1);

- d) une quatrième phase de croissance sur le substrat, dans une zone accolée à la première extrémité du guide de lumière (G1), d'une diode émissive (F1) dont le matériau possède un paramètre de maille sensiblement égal, multiple ou sous-multiple de celui du substrat ;

- e) une cinquième phase de croissance sur le substrat dans une zone accolée à la première couche de matériau ferrimagnétique, d'une diode réceptrice (R1) dont le matériau possède un paramètre de maille sensiblement égal, multiple ou sous multiple de celui du substrat ;

- f) un sixième phase de réalisation de circuits de traitement.

15. Procédé de réalisation selon la revendication 14, caractérisé en ce que la quatrième et la cinquième phase sont confondues.

16. Procédé de réalisation selon la revendication 14, caractérisé en ce qu'il comporte entre la troisième phase et la quatrième phase, une phase supplémentaire de découpe de la couche de matériau ferrimagnétique.

17. Procédé de réalisation selon la revendication 14, caractérisé en ce que la troisième phase permet la croissance sur le substrat d'une couche d'un matériau ferrimagnétique, accolée à la première extrémité du guide de lumière (G1), cette phase de croissance étant immédiatement suivie d'une opération d'usinage de la couche ainsi réalisée de façon à former un élément de transmission non réciproque (I1) possèdant un premier accès et un deuxième accès, le deuxième accès étant couplé à la première extrémité du guide de lumière (G1), et la diode émissive (E1) étant réalisée au cours de la quatrième phase de façon à être couplée au premier accès de l'élément de transmission non réciproque.

18. Procédé de réalisation selon l'une des revendications 14 et 17, caractérisé en ce que :

- au cours de la première phase, un deuxième guide de lumière (G2) colinéaire au premier (G1) est également réalisé, et possède aussi une première et une deuxième extrémités, la première extrémité étant distante de la deuxième extrémité du premier guide de lumière (G1) ;

- au cours de la deuxième phase, le deuxième guide de lumière est également masqué.

19. Procédé de réalisation selon la revendication 18, caractérisé en ce que :

- au cours de la troisième phase de croissance, une deuxième couche d'un matériau ferrimagnétique est réalisée entre la deuxième extrémité du premier guide et la première extrémité du deuxième guide.

20. Procédé de réalisation selon la revendication 18 dans lequel la diode émissive émet deux faisceaux colinéaires de directions opposées caractérisé en ce que :

- la diode émissive (E) de la quatrième phase est réalisée entre la deuxième extrémité du premier guide et la première extrémité du deuxième guide ;

- une deuxième couche de matériau ferrimagnétique (F2) est réalisée au cours de la troisième phase de façon a être couplée à la deuxième extrémité du deuxième guide (G2) ;

- une deuxième diode réceptrice (R2) est réalisée, au cours de la cinquième phase de façon a être accolée à la deuxième couche de matériau ferrimagnétique et à recevoir un des deux faisceaux émis par la diode émissive.

21. Procédé de réalisation selon la revendication 19, caractérisé en ce que la troisième phase permet la croissance sur le substrat, accolée à la première extrémité du deuxième guide de lumière (G2), d'une couche d'un matériau ferrimagnétique, cette phase de croissance étant immédiatement suivie d'une opération d'usinage de la couche ainsi réalisée de façon à former un deuxième élément de transmission non réciproque (I2) possèdant un premier accès et un deuxième accès, la diode émissive (E1) étant couplée au premier accès de l'élément de transmission non réciproque et le deuxième accès étant couplé à la première extrémité du deuxième guide de lumière (G1).

22. Procédé de réalisation selon l'une quelconque des revendications 14 à 20 caractérisé en ce que les phases de croissance sont réalisées par épitaxie.

23. Procédé de réalisation selon l'une quelconque des revendications à 14 à 20, caractérisé en ce que les phases de découpe et d'usinage sont réalisées par usinage ionique.

0262016

FIG_1

FIG_2

# FIG_3

R2   F2   G2   I2   E1 I1   G1   F1   R1

1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | JOURNAL OF APPLIED PHYSICS, vol. 53, no. 11, 2e partie, novembre 1982, pages 8263-8265, American Institute of Physics, New York, US; G. DORIATH et al.: "A sensitive and compact magnetometer using Faraday effect in YIG waveguide"<br>* Page 8264: "Magnetooptic probe" *<br>--- | 1,9,11, 13 | G 01 R  33/032 |
| A | EP-A-0 061 743  (NEC CORP.)<br>* Résumé; revendications 1-4 *<br>--- | 1 | |
| D,A | EP-A-0 130 901  (THOMSON-CSF)<br>* Figures 1-4 *<br>----- | 3,5 | |

DOMAINES TECHNIQUES RECHERCHES (Int. Cl.4)

G 01 R
G 02 F

Le présent rapport a été établi pour toutes les revendications

| Lieu de la recherche | Date d'achèvement de la recherche | Examinateur |
|---|---|---|
| LA HAYE | 14-12-1987 | HAASBROEK J.N. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)